# EUROPÄISCHE PATENTSCHRIFT

(11) **EP 0 484 756 B1**
(45) Veröffentlichungstag und Bekanntmachung des Hinweises auf die Patenterteilung: **10.01.1996**
(21) Anmeldenummer: 91118175.8
(22) Anmeldetag: 24.10.1991
(51) Int. Cl.: H01C 1/144

(54) **Widerstandsanordnung in SMD-Bauweise**
SMD-type resistor arrangement
Dispositif à résistance du type SMD

(30) Priorität: 05.11.1990 DE 9015206 U
(43) Veröffentlichungstag der Anmeldung: 13.05.1992
(73) Patentinhaber: Isabellenhütte Heusler GmbH KG, D-35683 Dillenburg (DE)
(72) Erfinder: Hetzler, Ullrich, Dr., W-6340 Dillenburg-Oberscheid (DE)
(74) Vertreter: Heusler, Wolfgang, Dipl.-Ing.

(56) Entgegenhaltungen:
- DE-A- 3 023 133
- DE-A- 3 201 434
- IBM TECHNICAL DISCLOSURE BULLETIN. Bd. 25, Nr. 12, Mai 1983, NEW YORK US,Seiten 6662-6663; AAKALU:'Double cantilever flip-chip resistor'

## Beschreibung

Die Erfindung betrifft eine Widerstandsanordnung in SMD-Bauweise gemäß dem Oberbegriff des Anspruchs 1.

Bei der industriellen Fertigung von Flachbaugruppen findet in zunehmendem Maße die SMD-Technik Anwendung (SMD ist die Abkürzung für Surface Mounted Devices). Bei dieser Oberflächenmontagetechnik werden die Bauelemente nicht mit drahtartigen Anschlußbeinchen an die Leiterplatte angeschlossen, sondern mit flachen Kontaktelementen aufgelötet. Das Auflöten erfolgt gewöhnlich durch eine Reflow-Methode (Wiederaufschmelzlöten), bei der die Anschlußkontakte des Bauelements und der Leiterplatte bedeckendes Lötzinn nach dem Bestücken durch Erwärmung verschmolzen wird, oder durch andere bekannte Methoden wie z.B. Schwallöten unter Verwendung eines Zinnbades. Ein wesentlicher Vorteil der Oberflächenmontage ist die Verkleinerung und bessere Ausnutzung des benötigten Platzes auf der Leiterplatte. Dieser Vorteil ist um so größer, je besser die Bauelemente und das Layout der Leiterplatte aufeinander abgestimmt sind.

Bei typischen SMD-Schichtwiderständen, die auch als Chip-Widerstände bezeichnet werden, ist die Widerstandsschicht über am Rand des Substrates befindliche leitende Verbindungsschichten mit zwei den Substratrand umgreifenden lötbaren Außenkappen od. dgl. verbunden, die als Kontaktelemente auf die Leiterplatte gelötet werden ("Design + Elektronik", Verlag Markt & Technik, Ausgabe 2 vom 20.1.1987, S. 74-82).

Soweit Netzwerke oder Arrays aus mehreren Schichtwiderständen bekannt sind, befinden sich diese in einem gemeinsamen Gehäuse, aus dem an die seitlichen Schichtränder angeschlossene Kontaktbeine herausgeführt sind, die bei Ausführung in SMD-Technik flache, parallel zur Leiterplattenebene abgebogene Anschlußenden haben können.

Aufgabe der Erfindung ist, eine insbesondere als Präzisionswiderstand oder Präzisionswiderstandsnetzwerk oder -array für industrielle Zwecke geeignete Anordnung zu schaffen, die eine feste und zuverlässige Oberflächenmontage ermöglicht und auch im Falle einer größeren Anzahl von Anschlüssen eine optimale geometrische Abstimmung mit dem Layout der zugehörigen Leiterplatte erlaubt, und die wenig Herstellungsaufwand erfordert.

Diese Aufgabe wird durch die im Anspruch 1 gekennzeichnete Widerstandsanordnung gelöst.

Bei der hier beschriebenen Widerstandsanordnung sind insbesondere im Fall von Netzwerken oder Arrays die auf die Leiterplatte aufzulötenden zahlreichen Anschlußflecken in der Regel über die Fläche der Widerstandsanordnung oder wenigstens über zwei entgegengesetzte Randbereiche verteilt. Hieraus ergibt sich eine selbst bei häufigen Erschütterungen sehr stabile Montage, was beispielsweise bei der Anwendung als Meßwiderstand im Automobilbau wichtig ist, und häufig auch eine Stabilisierung der Leiterplatte. Ein weiterer wichtiger Vorteil ist der geringe Aufwand bei der entsprechend kostengünstigen Herstellung, u.a. da in der Regel keine Metallschichten außer der Widerstandsschicht erforderlich sind, und weil im Gegensatz zu den bisher üblichen Chip-Widerständen und zu den bisher bekannten Widerstandsnetzwerken keine gesonderten Kontaktelemente wie Kappen oder Anschlußbeinchen seitlich nach außen geführt werden. Da die Anschlußflecken der auf die Leiterplatte gelöteten Widerstandsanordnung im Inneren der Anordnung unter dem Substrat verteilt sind, ergibt sich auch eine Platzersparnis. Wichtig ist ferner die weitgehende Wahlfreiheit für den geometrischen Ort der Anschlußflecken der Widerstandsanordnung und folglich auch der entsprechenden Anschlüsse auf der Leiterplatte. Die Widerstandsanordnung kann problemlos an ein optimales gegebenes oder gewünschtes Layout der Leiterplatte angepaßt werden. Bei Verwendung eines zweckmäßigen Substrates der Widerstandsanordnung ist schließlich auch eine günstige Wärmeabfuhr gewährleistet.

Die Erfindung eignet sich namentlich für hochbelastbare Präzisionsmeßwiderstandsanordnungen mit relativ geringen Widerstandswerten bis in den Milliohm-Bereich.

An zwei Ausführungsbeispielen wird die Erfindung näher erläutert. In der Zeichnung zeigen:
- Fig. 1: eine Draufsicht auf ein Widerstandsnetzwerk mit den über die Fläche der Anordnung verteilten Anschlußflecken;
- Fig. 2: einen Schnitt durch eine auf eine Leiterplatte gelötete Widerstandsanordnung gemäß der Erfindung;
- Fig. 3: eine Draufsicht auf einen Einzelwiderstand gemäß der Erfindung in Vierleitertechnik.

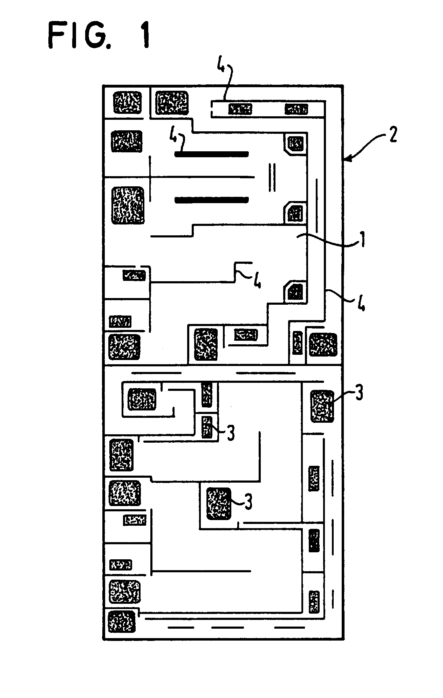

In Fig. 1 ist die geometrische Konfiguration eines Arrays aus mehreren Einzelwiderständen mit Vierleiteranschlüssen erkennbar. Die Vierleitertechnik, bei der bekanntlich jeder Widerstand außer den beiden Stromanschlüssen zwei gesonderte Spannungsanschlüsse hat, vermeidet bei niederohmigen Meßwiderständen den Einfluß der Zuleitungen und Kontaktstellen auf den Gesamtwiderstandswert und den Temperaturkoeffizienten.

Die Widerstände werden durch verschiedene Widerstandsbahnen gebildet, die ihrerseits in an sich bekannter Weise durch entsprechende Strukturierung aus einer einzigen Widerstandsmetallschicht 1 entstanden sind, welche sich auf einem an den seitlichen Rändern der Anordnung sichtbaren Substrat 2 befindet. Vorzugsweise ist die Widerstandsmetallschicht 1 eine auf das Substrat 2 geklebte Folie aus einer der bekannten Widerstandslegierungen etwa auf CuNi-Basis, deren Dicke z.B. zwischen 0,01 und 0,05 mm liegen kann.

Während sich bei bekannten Widerstands anordnungen dieser Art alle Anschlußflächen der Widerstandsmetallschicht am Rand der Anordnung befinden und dort mit externen Anschlußelementen verbunden sind, bestehen bei der hier beschriebenen Anordnung die auf die Leiterplatte aufzulötenden Kontaktelemente aus auf die Widerstandsmetallschicht 1 aufgebrachten, weitgehend über deren gesamte Fläche verteilten und von dem Substrat 2 vollständig überdeckten Anschußflecken 3, sogenannten Pads aus Lötzinn. Wie noch erläutert wird, sind die Anschlußflecken 3 auf die Widerstandsmetallschicht 1 siebgedruckt und umgeschmolzen. Bei den größeren Anschlußflecken handelt es sich um die Stromanschlüsse, die relativ hohe Ströme führen können, während die Spannungsanschlüsse der einzelnen Widerstände klei-ner bemessen sein können. Durch die Widerstandsbahnen zwischen je zwei Stromanschlüssen werden wie bei den bekannten Anordnungen die elektrischen Widerstandswerte definiert.

Die Verteilung der Anschlußflecken 3 über die Substratfläche, also ihre jeweilige geometrische Position ist entsprechend dem gegebenen Layout der zu bestückenden Leiterplatte und ihrer zugehörigen Anschlußleiter gewählt. Die Widerstandsmetallschicht 1 ist ihrerseits so gestaltet, daß sie an den Stellen der Anschlußflecken jeweils einen relativ großflächigen Widerstandsbahnbereich bildet, in den der jeweilige Anschlußfleck problemlos ohne Überbrückung einer der die Widerstandsbahn begrenzenden Einschnitte 4 hineinpaßt.

Bei Bedarf besteht die Möglichkeit, elektrisch nicht an die Schaltung anzuschließende besondere Pads ähnlich den Anschlußflecken 3 auf Bereichen der Widerstandsmetallschicht 1 anzubringen, die von den Widerstandsbahnen durch Einschnitte in die Schicht 1 vollständig isoliert sind. Diese gesonderten Pads würden beim Auflöten auf die Leiterplatte lediglich die mechanische Stabilität erhöhen.

Das Substrat 2 kann beispielsweise aus einer Aluminiumplatte bestehen, die gute Wärmeableitung und hohe mechanische Stabilität gewährleistet und relativ preisgünstig ist. Im Vergleich mit anderen Metallplatten haben Aluminium und dessen für den vorliegenden Zweck geeignete Legierungen außerdem den Vorteil, daß sie stets eine dünne Oxidhaut bilden, die mit Sicherheit eine Benetzung mit etwa um die Substratkanten fließendes Lötzinn und entsprechende Kurzschlüsse verhindern. Je nach Bedarfsfall können aber auch beliebige sonstige Substrate verwendet werden einschließlich solcher aus Kunststoffen, insbesondere GFK, sowie Keramik.

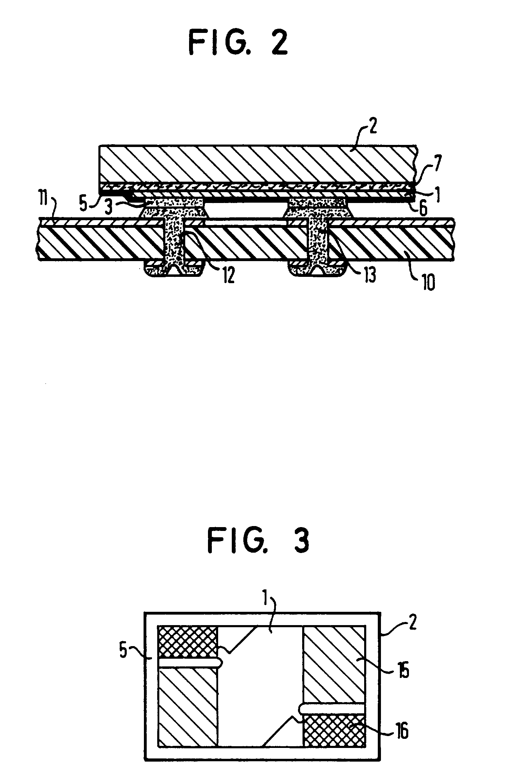

Fig. 2 zeigt eine Widerstandsanordnung der oben beschriebenen Art auf einer Leiterplatte 10, wobei die Anschlußflecken 3 gemäß der bekannten SMD-Technik auf die ebenfalls mit Lötzinnflecken 13 versehenen Anschlußleiter 11 der Leiterplatte 10 gelötet sind. Zwischen dem Substrat 2 und der Widerstandsmetallschicht 1 befindet sich eine Kleberschicht 7. Wie in Fig. 2 ferner erkennbar ist, reicht die Widerstandsmetallschicht 1 nicht ganz bis zum Substratrand, sondern sie läßt einen schmalen Randbereich 5 des Substrates 2 über dessen gesamten Umfang frei. Bei 6 ist eine Schicht aus hitzebeständigem, nicht zum Benetzen durch Lötzinn neigenden Lack an sich üblicher Art angedeutet, die den Randbereich 5 des Substrates 2 und die gesamte Widerstandsmetallschicht 1 bedeckt, jedoch die Anschlußflecken 3 frei läßt. Bei dem Ausführungsbeispiel gemäß Fig. 1 sind alle Anschlußflecken 3 vollständig vom Lack der Schicht 6 umgeben.

Beim Verschmelzen der Anschußflecken 3 der Widerstandsanordnung mit den Lötzinnflecken 13 der Leiterplatte 10 entstehen keine Kurzschlüsse auf der Leiterplatte oder Brücken benachbarter Widerstandsbahnen, da sich erfindungsgemäß die Widerstandsanordnung und deren Anschlußflecken durch Oberflächenspannung des flüssigen Lötzinns weitgehend selbsttätig zentrieren und ein Verlaufen des Lötzinns auch durch den "Lötstopplack" der Schicht 6 vermieden wird. Die bekannten Lötverfahren der SMD-Technik wie insbesondere die verschiedenen Reflow-Methoden sind auch so zuverlässig, daß nach dem Verschmelzen praktisch keine Gefahr elektrisch fehlerhafter Verbindungen oder "kalter Lötstellen" besteht. Überraschend hat sich gezeigt, daß man deshalb ohne weiteres in Kauf nehmen kann, daß bei der hier beschriebenen Widerstandsanordnung die vollständig von dem Substrat 2 überdeckten Lötstellen von dieser Seite aus nicht visuell inspiziert werden können.

Wenn besonders hohe Anforderungen an die Zuverlässigkeit gestellt werden, bestehen jedoch andere Möglichkeiten der Überprüfung. Beispielsweise kann man die elektrische Fehlerfreiheit in bekannter Weise durch programmgesteuerte Testmethoden gewährleisten, bei denen u.a. der Übergangswiderstand der Lötstellen gemessen werden kann. Bei der in Fig. 2 dargestellten Ausführungsform besteht aber auch eine Möglichkeit der visuellen Kontrolle der Lötverbindung von der Rückseite der Leiterplatte 10 her, nämlich mit Hilfe von Durchkontaktierungsbohrungen 12, die sich an den entsprechenden Stellen durch die Leiterplatte 10 hindurch erstrecken, und die durch den in die Bohrungen gelaufenen Teil des Lötzinns dessen Verflüssigung erkennen lassen. Die Durchkontaktierungen wirken außerdem als Pufferspeicher für das Lotmaterial, d.h. es ist stets eine ausreichende Menge und ggf. ein Überschuß an Lötzinn vorhanden.

Ein anderes Ausführungsbeispiel der Erfindung ist in Fig. 3 dargestellt. Hier handelt es sich um einen Einzelwiderstand mit Vierleiteranschlüssen, also mit zwei Stromanschlußflecken 15 und zwei Spannungsanschlußflecken 16. Der Aufbau der Anordnung kann weitgehend derjenigen nach Fig. 1 und 2 entsprechen. Auch hier sind also die Anschlußflecken 15, 16 auf eine die Widerstandsmetallschicht bildende Folie aufgedruckt und vollständig vom Substrat 2 überdeckt. Unter Umständen könnten die Anschlußflecken auch in an sich bekannter Weise durch galvanisches Verzinnen der Anschlußbereiche der Widerstandsmetallschicht 1 erzeugt werden, wenn die damit erzielbare geringere Schichtdicke in Sonderfällen ausreicht. Bei der in Fig. 3 dargestellten Ausführungsform kann es genügen, wenn die oben erwähnte Lackschicht nur den zwischen den Anschlußflecken 15, 16 liegenden inneren Bereich der Widerstandsmetallschicht 1 bedeckt.

Die Herstellung der hier beschriebenen Widerstandsanordnungen erfolgt zweckmäßig nach folgenden Verfahrensschritten:

Zunächst bildet man einen Verbundkörper durch Verpressen eines beidseitig anodisierten Aluminiumsubstrates (z.B. aus AlMg3-Blech) und einer Folie aus einer Widerstands legierung, zwischen denen sich eine Klebefolie befindet. Dann wird in an sich bekannter und üblicher Weise die Folie (Widerstandsmetallschicht 1) durch Fotoätzen in die gewünschte Form mit den erforderlichen Bahnstrukturen gebracht.

Anschließend wird die die Widerstandsfolie tragende Oberfläche des Verbundkörpers mit der Schicht 6 aus Lötstopplack beschichtet, und zwar vorzugsweise im Siebdruckverfahren, wobei die späteren Anschlußbereiche, also die Flächen für die Anschlußflecken 3 definiert und ausgespart werden.

Nun werden die Anschlußbereiche im Siebdruckverfahren mit einer Lotpaste bedruckt, die eine Mischung aus Lötzinn, Flußmittel und ggf. einem Kleber enthält. Die Lotpaste wird sodann durch externe Wärme ähnlich wie bei bekannten Reflow-Methoden wie z.B. Infrarot-, Dampfphasen-, Heißgas- oder Wärmeplattenlöten verflüssigt. Bei diesem Umschmelzvorgang entsteht aus der Lotpaste eine kompakte Lotperle, die den betreffenden Anschlußfleck 3 bildet. Durch eine Ultraschallbad-Behandlung zur Entfernung von Flußmittelresten kann die Widerstandsanordnung gereinigt werden.

Wenn die elektrischen Widerstandswerte keine weiten Toleranzen haben, wird die Widerstandsanordnung nach dem Aufdrucken der Anschlußflecken auf die jeweiligen Widerstandssollwerte abgeglichen. Der Abgleich erfolgt in bekannter Weise durch Einschnitte in die Widerstandsmetallschicht.

Vor oder nach dem Abgleich kann der Verbundkörper je nach Bedarf und Anwendungsfall in einzelne Bauelemente zerteilt werden.

Als Widerstandsfolie kommen insbesondere alle Legierungen auf CuNi-Basis in Betracht, die vom Lot der Lotpaste gut benetzt werden. Bei anderen Legierungen kann eine galvanische Vorbehandlung (z.B. Verzinnung) der Anschlußbereiche vor Aufbringen der eigentlichen Anschlußflecken erforderlich sein.

## Patentansprüche

1. Widerstandsanordnung in SMD-Bauweise mit einer eine oder mehrere Widerstandsbahnen bildenden, auf einer Oberfläche eines Substrates (2) angeordneten Widerstandsmetallschicht (1), insbesondere einer Folie aus einer Widerstandslegierung, und mit zwei oder mehr mit den Widerstandsbahnen verbundenen Anschlußflecken (3) aus Lötmetall, die wenigstens annähernd parallel zu der Substratoberfläche liegende Anschlußflächen haben, mit denen die Widerstandsanordnung flach auf Anschlußleiter einer Leiterplatte auflötbar ist, und von denen mindestens ein Anschlußfleck von dem Substrat (2) vollständig überdeckt ist, **dadurch gekennzeichnet**, daß die auf die Leiterplatte auflötbaren Anschlußflecken (3) vollständig und unmittelbar auf die Widerstandsmetallschicht (1) aufgebracht sind.

2. Widerstandsanordnung nach Anspruch 1, **dadurch gekennzeichnet**, daß alle Anschlußflecken (3) von dem Substrat (2) vollständig überdeckt sind.

3. Widerstandsanordnung nach Anspruch 1 oder 2, **dadurch gekennzeichnet**, daß die Anschlußflecken (3) im wesentlichen aus Lötzinn bestehen.

4. Widerstandsanordnung nach einem der vorangehenden Ansprüche, **dadurch gekennzeichnet**, daß die Anschlußflecken (3) auf die Widerstandsmetallschicht (1) aufgedruckt und umgeschmolzen sind.

5. Widerstandsanordnung nach einem der vorangehenden Ansprüche, **dadurch gekennzeichnet**, daß die Widerstandsmetallschicht (1) mindestens einen in Vierleitertechnik ausgebildeten Widerstand mit vier Anschlußflecken (3,15,16) bildet.

6. Widerstandsanordnung in SMD-Bauweise mit einer auf einer Oberfläche eines Substrates (2) angeordneten Widerstandsmetallschicht (1), insbesondere einer Folie aus einer Widerstandslegierung, welche einen oder mehrere bahnförmige Widerstände in Vierleitertechnik mit je vier mit den Widerstandsbahner verbundenen metallischen Kontaktelementen bildet, die wenigstens annähernd parallel zu der Substratoberfläche liegende Anschlußflächen haben, mit denen die Widerstandsanordnung flach auf Anschlußleiter einer Leiterplatte auflötbar ist, **dadurch gekennzeichnet**, daß die auf die Leiterplatte auflötbaren Kontaktelemente aus auf die Widerstandsmetallschicht (1) Vollständig und unmittelbar aufgebrachten Anschlußflecken (3) aus Lötmetall bestehen und alle vier oder mehr Anschlußflecken von dem Substrat (2) vollständig überdeckt sind.

7. Widerstandsanordnung nach einem der vorangehenden Ansprüche, **dadurch gekennzeichnet**, daß die Widerstandsmetallschicht (1) mit Ausnahme der Anschlußflecken (3) auf der dem Substrat (2) abgewandten Seite von einer Isolierlackschicht (6) bedeckt ist.

8. Widerstandsanordnung nach einem der vorangehenden Ansprüche, **dadurch gekennzeichnet**, daß das Substrat (2) aus Aluminium, einer Aluminiumlegierung oder einem anderen Metall besteht, das nicht durch Lötzinn benetzbar ist.

9. Widerstandsanordnung nach einem der Ansprüche 1 bis 7, **dadurch gekennzeichnet**, daß das Substrat (2) aus Keramik besteht.

10. Widerstandsanordnung nach einem der vorangehenden Ansprüche, **dadurch gekennzeichnet**, daß die Anschlußflecken (3) der Widerstandsmetallschicht (1) auf Kontaktflächen (11) der Leiterplatte (10) gelötet sind, von denen eine Durchkontaktierungsbohrung (12) auf die Rückseite der Leiterplatte (10) führt.

11. Widerstandsanordnung nach einem der vorangehenden Ansprüche, **dadurch gekennzeichnet**, daß die Widerstandsmetallschicht (1) aus einer Cu-Legierung besteht.

12. Verfahren zum Herstellen einer Widerstandsanordnung nach einem der vorangehenden Ansprüche, **gekennzeichnet** durch folgende Verfahrensschritte:
- auf ein Substrat wird eine Folie aus einer Widerstandslegierung geklebt;
- durch selektives Entfernen von Teilen der Folie beispielsweise durch Fotoätzen wird eine Widerstandsbahnstruktur gebildet;
- die die Folie tragende Oberseite des aus der Folie und dem Substrat gebildeten Verbundkörpers wird mit einer Schicht aus Isoliermaterial bedeckt, aus der für Anschlußflecken bestimmte Anschlußbereiche ausgespart oder entfernt werden;
- die Anschlußbereiche in den Aussparungen der Isoliermaterial schicht werden mit Lötmetall bedeckt, das die Anschlußflecken der Widerstandsanordnung bildet.

13. Verfahren nach Anspruch 12, **dadurch gekennzeichnet**, daß die Isoliermaterialschicht und/oder das Lötmetall durch Siebdruck aufgebracht werden.

14. Verfahren nach Anspruch 12 oder 13, **dadurch gekennzeichnet**, daß das Lötmetall in Form einer Lötzinn und ein Flußmittel enthaltenden Mischung aufgebracht und dann durch externe Wärme verflüssigt und in kompakte Lötperlen umgeschmolzen wird, die die Anschlußflecken der Widerstandsanordnung bilden.

## Claims

1. Resistor assembly of SMD construction with a resistive metallic layer (1), particularly a film of a resistive alloy, which forms one or more resistive tracks and is arranged on a surface of a substrate (2), and with two or more connector pads (3) of soldering metal, which are connected to the resistive tracks and which have connection regions disposed at least approximately parallel to the substrate surface with which the resistor assembly may be soldered flat to connecting leads of a printed circuit board and of which at least one connector pad is completely covered by the substrate (2) , characterised in that the connector pads (3), which may be soldered to the printed circuit board, are applied completely and directly to the resistive metal layer (1).

2. Resistor assembly as claimed in Claim 1, characterised in that all the connector pads (3) are completely covered by the substrate (2).

3. Resistor arrangement as claimed in Claims 1 and 2, characterised in that the connector pads (3) consist substantially of solder.

4. Resistor arrangement as claimed in one of the preceding claims, characterised in that the connector pads (3) are printed onto the resistive metal layer (1) and are re-melted.

5. Resistor assembly as claimed in one of the preceding claims, characterised in that the resistive metallic layer (1) defines at least one resistor with four connector pads (3, 15, 16) formed in accordance with four-pole technology.

6. Resistor assembly of SMD type with a resistive metallic layer (1), particularly a film of a resistive alloy, which is disposed on a surface of a substrate (2) and which forms one or more track-shaped resistors of four-pole type with four respective metallic contact elements, which are connected to the resistive tracks and which have connector surfaces, which extend at least approximately parallel to the substrate surface and with which the resistor assembly may be soldered flat to connecting leads on a printed circuit board, characterised in that the contact elements, which are solderable to the printed circuit board, comprise contact pads (3) of soldering metal which are applied completely and directly to the resistive metallic layer (1) and all four or more connector pads are completely covered by the substrate (2).

7. Resistor assembly as claimed in one of the preceding claims, characterised in that the resistive metallic layer (1) is covered by an insulating lacquer layer (6) with the exception of the connector pads (3) on the side directed away from the substrate (2).

8. Resistor assembly as claimed in one of the preceding claims, characterised in that the substrate (2) comprises aluminium, an aluminium alloy or another metal which is not wettable by solder.

9. Resistor assembly as claimed in one of Claims 1 to 7, characterised in that the substrate (2) comprises ceramic material.

10. Resistor arrangement as claimed in one of the preceding claims, characterised in that the connector pads (3) of the resistive metallic layer (1) are soldered to contact surfaces (11) of the printed circuit board (10), from which a contact through-bore (12) leads to the rear surface of the printed circuit board.

11. Resistor assembly as claimed in one of the preceding claims, characterised in that the resistive metallic layer (1) comprises a Cu-alloy.

12. Method of manufacturing a resistor assembly as claimed in one of the preceding claims, characterised by the following method steps:
- a film of a resistive alloy is adhered to a substrate;
- a resistive track structure is formed by selective removal of parts of the film, for instance by photo-etching;
- the upper surface, which carries the film, of the composite body formed by the film and the substrate is covered with a layer of insulating material from which certain connecting regions are recessed or removed for connector pads;
- the connection regions in the recesses in the insulating material layer are covered with soldering metal which forms the connector pads of the resistor assembly.

13. Method as claimed in Claim 12, characterised in that the insulating material layer and/or the soldering metal are applied by screen printing.

14. Method as claimed in Claim 12 or 13, characterised in that the soldering metal is applied in the form of a mixture containing solder and a fluxing agent and is then liquified by external heat and is re-melted into compact solder beads which form the connector pads of the resistor assembly.

## Revendications

1. Agencement de résistances du type SMD comportant une couche métallique résistive (1), notamment une feuille d'un alliage pour résistances, disposée sur une surface d'un substrat (2) et formant un ou plusieurs chemins de résistance, et comportant deux pastilles de connexion (3), ou davantage, en métal de brasage, reliées aux chemins de résistance, lesquelles ont des surfaces de connexion situées au moins approximativement parallèles à la surface du substrat, par lesquelles on peut braser l'agencement de résistances à plat sur une plaquette de circuits, et dont au moins une de ces pastilles de connexion (3) est totalement recouverte par le substrat (2), caractérisé en ce que les pastilles de connexion (3) destinées à être brasées sur la plaquette de circuits, sont appliqués totalement et directement sur la couche métallique résistive (1).

2. Agencement de résistances selon la revendication 1, caractérisé en ce que toutes les pastilles de connexion (3) sont totalement recouvertes par le substrat (2).

3. Agencement de résistances selon la revendication 1 ou 2, caractérisé en ce que les pastilles de connexion (3) sont essentiellement constituées d'étain de brasage.

4. Agencement de résistances selon l'une des revendications précédentes, caractérisé en ce que les pastilles de connexion (3) sont appliquées sur la couche métallique résistive (1) et brasées par fusion.

5. Agencement de résistances selon l'une des revendications précédentes caractérisé en ce que la couche métallique résistive (1) constitue au moins une résistance à quatre pastilles de connexion (3, 15, 16) réalisée avec la technique à quatre fils.

6. Agencement de résistances du type SMD, comportant une couche métallique résistive (1), notamment une feuille en un alliage pour résistances, disposée sur une surface de substrat (2), laquelle feuille constitue une ou plusieurs résistances en forme de chemins, comportant selon la technique à quatre fils, respectivement quatre éléments de contact métalliques reliés aux chemins de résistance, lesquels ont des surfaces de connexion situées au moins approximativement parallèles à la surface du substrat, par lesquelles l'agencement de résistances peut être brasé à plat sur les fils de connexion électrique d'une plaquette de circuits, caractérisé en ce que les éléments de contact destinés à être brasés sur la plaquette de circuits sont constitués par des pastilles de connexion (3) en métal de brasage appliquées totalement et directement sur la couche métallique résistive (1), et que les quatre pastilles de connexion, ou davantage, sont totalement recouvertes par le substrat (2).

7. Agencement de résistances selon l'une des revendications précédentes, caractérisé en ce que la couche métallique résistive (1) est recouverte par une couche de vernis isolant (6), à l'exception des pastilles de connexion (3), sur le côté opposé au substrat (2).

8. Agencement de résistances selon l'une des revendications précédentes caractérisé en ce que le substrat (2) est en aluminium, en alliage d'aluminium ou en un autre métal, qui ne peut pas être mouillé par l'étain de brasage.

9. Agencement de résistance selon l'une des revendications 1 à 7, caractérisé en ce que le substrat (2) est en céramique.

10. Agencement de résistances selon l'une des revendications précédentes, caractérisé en ce que les pastilles de connexion (3) de la couche métallique résistive (1) sont brasées sur des surfaces de contact (11) de la plaquette de circuits (10), un trou traversant métallisé (12) allant de celles-ci jusqu'au côté postérieur de la plaquette de circuits (10).

11. Agencement de résistances selon l'une des revendications précédentes, caractérisé en ce que la couche métallique résistive (1) est en alliage de cuivre.

12. Procédé pour fabriquer un agencement de résistances selon l'une des revendications précédentes, caractérisé par les étapes suivantes :
- on colle sur un substrat une feuille en un alliage pour résistances,
- en ôtant sélectivement des parties de la feuille, par exemple par photogravure, on forme une structure de chemins de résistance;
- le côté supérieur, portant la feuille, du corps composite formé de la feuille et du substrat, est recouvert d'une couche d'un matériau isolant, dans laquelle on réserve ou on enlève les zones de connexion prévues pour les pastilles de connexion ;
- les zones de connexion dans les évidements de la couche de matériau isolant sont recouvertes de métal de brasage, qui constitue les pastilles de connexion de l'agencement de résistances.

13. Procédé selon la revendication 12, caractérisé en ce que la couche de matériau isolant et/ou le métal de brasage sont appliqués par sérigraphie.

14. Procédé selon la revendication 12 ou 13, caractérisé en ce que le métal de brasage est appliqué sous la forme d'un mélange contenant l'étain de brasage et un fondant, puis il est liquéfié par chaleur externe et brasé par fusion sous forme de perlures de brasage compactes, qui constituent les pastilles de connexion de l'agencement de résistances.
